# EUROPÄISCHE PATENTSCHRIFT

(11) **EP 0 665 440 B1**
(45) Veröffentlichungstag und Bekanntmachung des Hinweises auf die Patenterteilung: **08.01.1997**
(21) Anmeldenummer: 95106157.1
(22) Anmeldetag: 22.10.1992
(51) Int. Cl.: G01R 19/15

(54) **Geräte zur Anzeige eines stattgefundenen Stromdurchganges in Leitungen von Blitzschutzanlagen**
Device for indicating that a current passage occured in the conductors of lightning protection equipment
Appareil pour l'indication d'un courant ayant parcouru des conducteurs d'équipement par foudre

(30) Priorität: 24.10.1991 AT 2121/91
(43) Veröffentlichungstag der Anmeldung: 02.08.1995
(62) Teilanmeldung aus: 92890227.9
(73) Patentinhaber: Gerstmaier, Siegfried, A-1150 Wien (AT)
(72) Erfinder: Cerny, Alfred, A-2345 Brunn am Gebirge (AT)
(74) Vertreter: Rippel, Andreas, Dipl.-Ing.

(56) Entgegenhaltungen:
- EP-A- 0 350 662
- DD-A- 215 864
- FR-A- 2 497 957
- PATENT ABSTRACTS OF JAPAN vol. 014 no. 585 (P-1148) ,27.Dezember 1990 & JP-A-02 253177 (NGK INSULATORS LTD) 11.Oktober 1990,
- PATENT ABSTRACTS OF JAPAN vol. 014 no. 585 (P-1148) ,27.Dezember 1990 & JP-A-02 253177

## Beschreibung

Die Erfindung bezieht sich auf ein Gerät zur Anzeige eines stattgefundenen Stromdurchganges in einer Leitung einer Blitzschutzanlage, bei dem an oder nahe der Leitung ein bei Stromdurchgang ansprechender Magnet angeordnet sowie eine Einrichtung zur Sichtbarmachung des Ansprechens des gerätes auf einen derartigen Stromdurchgang vorgsehn ist.

Derartige Geräte sind zweckmäßig, um jederzeit feststellen zu können, ob ein Blitzeinschlag stattgefunden hat. War dies der Fall, könnte die Blitzschutzanlage beschädigt worden sein und es wäre daher eine Überprüfung derselben notwendig.

Bei einem aus dem Dokument Patent Abstracts of Japan, Band 014, Nr. 585 (P-1148), 27/12/1990, bekannten Gerät der eingangs genannten Art sind eigene Organe angeordnet, die den Strom in Magnetismus umwandeln, wobei eine Spule Magnetpulver veranlaßt, zu einem in einem durchsichtigen Gehäuse befindlichen Permanentmagneten zu wandern. Befindet sich das Magnetpulver daher an dem Permanentmagneten hat ein Stromdurchgang bzw. ein Blitzeinschlag stattgefunden.

Das bekannte Gerät ist sehr kompliziert und überdies ist der Übergang des Magnetpulvers von der Spule zum Permanentmagneten nicht leicht sichtbar.

Die Erfindung hat es sich daher zum Ziel gesetzt, ein Gerät zu schaffen, das bei einfachem Aufbau eine sichere Anzeige gewährleist.

Erreicht wird dies dadurch, daß ein einen Teil der Leitung bildender Metallstab vorgesehen ist, an dem der Magnet vor Stromdurchgang haftet, sowie daß im gerät eine Tasche angeordnet ist, in die der auf einen stattfindenden Stromdurchgang ansprechende Magnet fällt.

In einem solchen Gerät fällt bei Stromdurchgang der Magnet von dem Metallstab ab und fällt in die Tasche, was leicht wahrgenommen werden kann.

Der fehlende Magnet am Metallstab kann den stattgefundenen Stromdurchgang anzeigen, bei einer bevorzugten Ausführungsform der Erfindung ist überdies die Tasche mit einem Schaubereich versehen, so daß der in der Tasche liegende Magnet sichtbar ist. Eine besonders sichere Wirkung des erfindungsgemäßen Gerätes wird erreicht, wenn der Metallstab aus nichtrostendem Stahl besteht.

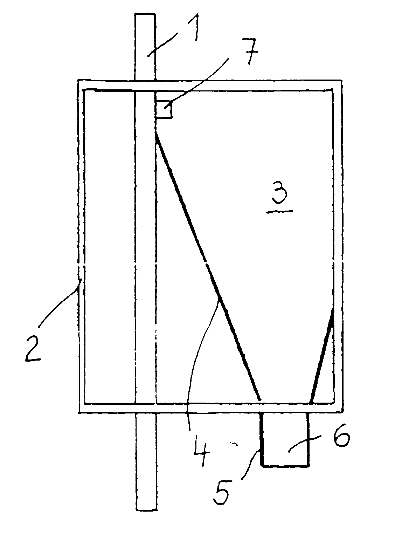

Nachstehend ist die Erfindung an Hand eines in der Zeichnung dargestellten Ausführungsbeispieles näher beschrieben. Dabei zeigt die einzige Figur in Ansicht ein Gerät nach der Erfindung.

Gemäß der Zeichnung ist ein Metallstab 1 aus nichtrostendem Stahl durch ein Gehäuse 2 hindurchgeführt. Dieses Gehäuse 2 besteht aus nichtmagnetisierbarem Material, insbesondere aus einem Kunststoff. Die Vorderseite des Gehäuses 2 ist mit einer durchsichtigen Scheibe 3 abgedeckt.

Eine schräge Führung 4 erstreckt sich vom oberen Teil des Gehäuses 2 bis zu einer Tasche 5, die ebenfalls mit einer durchsichtigen Scheibe 6 abgedeckt ist. Oberhalb des oberen Endes der Führung 4 haftet am Metallstab 1 ein Magnet 7.

Der Metallstab 1 ist derart mit einer Blitzschutzanlage verbunden, daß bei einem Blitzeinschlag durch ihn Strom fließt. Durch diesen Strom wird ein Magnetfeld induziert, das den Magneten 7 zum Abfallen bringt. Der Magnet 7 fällt daher, geleitet von der Führung 4, in die Tasche 5 und es kann so leicht festgestellt werden, ob ein Stromdurchgang stattgefunden hat.

Im Rahmen der Erfindung sind zahlreiche Abänderungen möglich. So könnte bei einer Ausführung der Metallstab 1 waagrecht oberhalb einer unter dem anliegenden Magneten 7 vorgesehenen Tasche angeordnet werden. Die Tasche od.dgl. müßte auch nicht mit einem Schaubereich versehen werden, weil auch das Abfallen des Magneten 7 schon sichtbar ist.

## Patentansprüche

1. Gerät zur Anzeige eines stattgefundenen Stromdurchganges in einer Leitung einer Blitzschutzanlage, bei dem an oder nahe der Leitung ein bei Stromdurchgang ansprechender Magnet(7) angeordnet sowie eine Einrichtung zur Sichtbarmachung des Ansprechens des Magneten (7) des Gerätes auf einen derartigen Stromdurchgang vorgesehen ist, **dadurch gekennzeichnet**, daß ein einen Teil der Leitung bildender Metallstab (1) vorgesehen ist, an dem der Magnet (7) vor Stromdurchgang haftet, sowie daß in gerät eine Tasche (5) angeordnet ist, in die der auf einen stattfindenden Stromdurchgang ansprechende Magnet (7) fällt.

2. Gerät nach Anspruch 1, **dadurch gekennzeichnet,** daß die Tasche (5) mit einem Schaubereich versehen ist.

3. Gerät nach Anspruch 1 oder 2, **dadurch gekennzeichnet,** daß der Metallstab (1) aus nicht rostendem Metall besteht.

## Claims

1. Appliance for indicating the passage of current in the lead of a lightning protection installation, in which, on or near the lead, a magnet (7) responding to the passage of current is arranged and a device for displaying the response of the appliance to a current passage of this kind,
characterised in that
a metal bar (1), forming part of the wiring, is provided, to which the magnet (7) adheres before current passes through, and in that there is arranged in the appliance a pocket, into which the magnet (7), responding to the passage of current, falls.

2. Appliance according to claim 1,
characterised in that
the pocket (5) is provided with a display area.

3. Appliance according to claim 1 or 2,
characterised in that
the metal bar consists of rustproof metal.

## Revendications

1. Appareil pour l'indication d'un passage de courant ayant eu lieu dans un conducteur d'un dispositif parafoudre, dans lequel on a placé sur le conducteur ou à proximité de celui-ci un aimant (7) réagissant lors du passage de courant et pour lequel on a prévu un dispositif permettant de visualiser la réponse de l'appareil à un tel passage de courant, **caractérisé en ce qu**'on a prévu une barrette métallique (1) formant une partie du conducteur et à laquelle adhère l'aimant (7) avant le passage du courant et en ce qu'on a disposé dans l'appareil une poche, (5) dans laquelle tombe l'aimant (7) qui répond à un passage de courant en cours.

2. Appareil selon la revendication 1 **caractérisé en ce que** la poche (5) est pourvue d'une fenêtre.

3. Appareil selon la revendication 1 ou 2 **caractérisé en ce que** la barrette métallique (1) est faite en un métal inoxydable.
